(19) Europäisches Patentamt / European Patent Office / Office européen des brevets

(11) **EP 3 850 748 B1**

(12) **EUROPÄISCHE PATENTSCHRIFT**

(45) Veröffentlichungstag und Bekanntmachung des Hinweises auf die Patenterteilung:
**30.10.2024  Patentblatt 2024/44**

(21) Anmeldenummer: **19748778.8**

(22) Anmeldetag: **29.07.2019**

(51) Internationale Patentklassifikation (IPC):
*H02P 29/032* (2016.01)  *H02P 29/68* (2016.01)
*H02P 29/02* (2016.01)  *H02P 3/12* (2006.01)
*H02P 3/14* (2006.01)  *B60L 3/00* (2019.01)
*B60L 7/02* (2006.01)  *B60L 15/20* (2006.01)
*H03K 17/08* (2006.01)  *G01R 31/26* (2020.01)
*H02M 5/458* (2006.01)  *H02M 1/32* (2007.01)

(52) Gemeinsame Patentklassifikation (CPC):
**G01R 31/2632; B60L 3/003; B60L 7/02; B60L 15/2009; H02M 5/458; H02P 3/12; H02P 3/14; H02P 29/02; H02P 29/032; H02P 29/68;** B60L 2240/421; B60L 2240/423; B60L 2240/525; H02M 1/327

(86) Internationale Anmeldenummer:
**PCT/EP2019/070313**

(87) Internationale Veröffentlichungsnummer:
**WO 2020/052851 (19.03.2020 Gazette 2020/12)**

(54) **VERFAHREN ZUM REGELN DER DREHZAHL ODER DES DREHMOMENTS EINES MOTORS, DREHZAHLREGELUNGSSYSTEM UND STEUERGERÄT**

METHOD FOR CONTROLLING THE ROTATIONAL SPEED OR THE TORQUE OF A MOTOR, ROTATIONAL SPEED CONTROL SYSTEM AND CONTROL DEVICE

PROCÉDÉ POUR LE RÉGLAGE DU RÉGIME OU DU COUPLE D'UN MOTEUR, SYSTÈME DE RÉGLAGE DE RÉGIME ET APPAREIL DE COMMANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.09.2018   DE 102018215432**

(43) Veröffentlichungstag der Anmeldung:
**21.07.2021   Patentblatt 2021/29**

(73) Patentinhaber: **Continental Automotive Technologies GmbH**
**30175 Hannover (DE)**

(72) Erfinder:
• **GUNSELMANN, Christian**
**60488 Frankfurt am Main (DE)**
• **BUDIANU, Bogdan**
**60488 Frankfurt am Main (DE)**
• **DONNER, Andreas**
**60488 Frankfurt am Main (DE)**
• **CIMPOESU, Albert**
**60488 Frankfurt am Main (DE)**

(74) Vertreter: **Continental Corporation**
**c/o Continental Automotive Technologies GmbH**
**Intellectual Property**
**Guerickestraße 7**
**60488 Frankfurt a. Main (DE)**

(56) Entgegenhaltungen:
EP-A2- 0 161 906        WO-A1-2011/073829
DE-A1- 102016 210 900   DE-A1- 102017 103 573
KR-A- 20150 105 182     US-A1- 2017 085 208

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 850 748 B1

**Beschreibung**

Die Erfindung betrifft ein Verfahren zum Regeln der Drehzahl oder des Drehmoments eines Motors nach Anspruch 1, ein Drehzahlregelungssystem nach Anspruch 8 und ein Steuergerät nach Anspruch 9.

US 2017085208 A1 zeigt Steuervorrichtung für eine Fahrzeugkarosserie zum Öffnen/Schließen, umfassend eine Antriebsvorrichtung, die einen sich öffnenden/schließenden Körper eines Fahrzeugs unter Verwendung eines Motors als Antriebsquelle antreibt; eine Motortreiberschaltung, eine Überbrückungsschaltung und eine Spannungsklemmvorrichtung. Ziel ist es, wenn die Stromversorgung der Motortreiberschaltung unterbrochen wird, eine Bremskraft basierend auf einer regenerativen Bremswirkung derart zu gestalten, dass eine sanfte Bewegung des Öffnungs-/Schließkörpers erreicht wird.

DE 102017103573 A1 zeigt eine Motorsteuervorrichtung, die einen Anhalteweg eines Motors verkürzen kann und gleichzeitig eine Erzeugung eines Niederspannungsalarms nach einem Stromausfall einer Energiequelle verhindert.

WO 2011073829 A1 zeigt ein elektronisches Vorschaltgerät, was eine Lampe mit Strom versorgt. Ein PFC-Wandler und ein DC/AC-Wandler reagieren auf ein Kompensatorsignal, um die Leistung an die Lampe zu reduzieren, wenn der Zustandsparameter des elektronischen Vorschaltgeräts einen Zustandsparameterschwellenwert des elektronischen Vorschaltgeräts überschreitet.

Bei der Anwendung eines BLDC-Motors zum Antrieb eines hydraulischen Kolbens im Bremssystem eines Fahrzeugs wird zum Modulieren des Bremsdrucks die Rotation des Motors über einen Spindelgewindetrieb umgewandelt in eine Linearbewegung des Kolbens. Zum Bremsen wird auf diese Weise elektrische Energie in hydraulische Energie umgewandelt. Am Ende eines Bremsvorgangs wird der Motor in umgekehrte Richtung betrieben, so dass die hydraulische Energie über den Spindelgewindetrieb vom BLDC-Motor zurück in elektrische Energie gewandelt wird. Dieser Betrieb wird auch Rekuperation genannt. Die elektrische Energiemenge ist abhängig von der gespeicherten hydraulischen Energie, dem Wirkungsgrad des Spindelgewindes, sowie dem Wirkungsgrad des elektrischen Antriebs.

Für die Abfuhr der rekuperierten elektrischen Energie gibt es folgende Möglichkeiten:

    a) Rückspeisung in das elektrische Bordnetz des Fahrzeugs
    b) Rückspeisung in einen Energiespeicher
    c) Umwandlung in thermische Energie

Wenn der Fahrer stark bremst (große hydraulische Energie) und am Ende des Bremsvorgangs den Fuß schnell vom Pedal zurücknimmt (kurze Zeitspanne für die Rekuperation) muss in kurzer Zeit viel elektrische Energie abgeführt werden. Die genannten Möglichkeiten a und b sind dafür nicht geeignet.

Eine Rückspeisung ins Fahrzeugbordnetz (Möglichkeit a) würde zu Spannungsschwankungen und Spannungsüberhöhungen führen und möglicherweise zu Schäden an elektrischen Systemen. Für eine Rückspeisung in einen Energiespeicher (Möglichkeit b) können Kondensatoren verwendet werden. Im Fall eines starken Bremsvorgangs würde die Spannung der Kondensatoren entweder sehr hoch ansteigen (Nachteil: Beschädigung der Steuergeräte) oder die Kapazität der Kondensatoren müsste sehr groß dimensioniert werden (Nachteil: hohe Kosten).

Zur Umwandlung der Rekuperationsenergie in thermische Energie (Möglichkeit c) werden nach dem Stand der Technik Leistungswiderstände (zur Umwandlung hoher Energie) oder Leistungs-Zenerdioden bzw. Suppressordioden (zur Umwandlung mittlerer Energie) verwendet. Die Dioden sind die geeigneten Bauelemente, um die elektrische Energiemenge eines starken und abrupt endenden Bremsvorgangs aufzunehmen (in thermische Energie umzuwandeln) und gleichzeitig die Spannung effektiv zu begrenzen. Je nach Energiemenge und Dynamik (Zeitspanne der Rekuperation) steigt bei der Umwandlung die Sperrschichttemperatur der Suppressordiode an. Die Sperrschichttemperatur der Diode ist allerdings nicht bekannt. Steigt sie über einen Grenzwert, so kann die Diode geschädigt oder zerstört werden.

Um eine zu große Eigenerwärmung zu verhindern, müsste der Diodenstrom (in Sperrrichtung) begrenzt werden. Dieser ist jedoch in der Regel nicht bekannt. Nach dem Stand der Technik wird daher die Motordrehzahl generell mit einem fest eingestellten Wert limitiert.

Dies hat jedoch den Nachteil, dass durch die pauschale Strom- bzw. Drehzahlbegrenzung das System unnötig in seiner Funktion beschränkt wird. Bei einer unkritischen (niedrigen) Sperrschichttemperatur wäre nämlich ein höherer Diodenstrom bzw. eine höhere Motordrehzahl unproblematisch. Darüber hinaus kann es auch mit einer pauschalen Begrenzung zu einer thermischen Zerstörung der Diode kommen, da die Diodentemperatur nicht bekannt ist.

Es ist somit die Aufgabe der Erfindung, ein Verfahren und eine Vorrichtung bereitzustellen, welche(s) die Strom- bzw. Drehzahlbegrenzung zum Schutz der Suppressordiode gegenüber dem Stand der Technik verbessert.

Die Aufgabe wird gelöst durch die unabhängigen Ansprüche.

Die Erfindung betrifft ein Verfahren zur Regelung der Drehzahl oder des Drehmoments eines Motors zum Schutz einer Suppressordiode in einem Steuergerät eines Fahrzeugs, wobei die Suppressordiode Rekuperationsenergie des Motors in thermische Energie umwandelt und wobei für das Verfahren folgende Schritte durchgeführt werden:

- Ermitteln der aktuellen Sperrschichttemperatur und/oder Diodenspannung der Suppressordiode,
- Regeln der Drehzahl oder des Drehmoments des Motors mittels der aktuellen Sperrschichttemperatur und/oder Diodenspannung (in Sperrrichtung) derart, dass die Sperrschichttemperatur der Suppressordiode einen vorbestimmten Sperrschichttemperaturgrenzwert nicht überschreitet.

Erfindungsgemäß wird zur Ausführung des Verfahrens eine Derratinginformation herangezogen. Dabei ist in der Deratinginformation eine Abhängigkeit zwischen der Sperrschichttemperatur bzw. Diodenspannung und einem Leistungsfaktor hinterlegt.

Bevorzugt handelt es sich um einen dreiphasigen Motor. Der Sperrschichttemperaturgrenzwert ist bevorzugt so definiert, dass der Wert unterhalb eines kritischen Werts liegt, bei dem eine Überhitzung und/oder Zerstörung der Diode (= Suppressordiode) eintreten würde.

Durch das Regeln der Drehzahl bzw. des Drehmoments des Motors derart, dass die Sperrschichttemperatur der Suppressordiode einen vorbestimmten Sperrschichttemperaturgrenzwert nicht überschreitet, wird die Suppressordiode vor Überhitzung und Zerstörung geschützt. Die aktuelle Sperrschichttemperatur wird bevorzugt indirekt ermittelt, indem die aktuelle Diodenspannung gemessen wird. Dadurch, dass die Sperrschichttemperatur mit der Diodenspannung in einer linearen Korrelation steht, ist eine Umrechnung der Diodenspannung in die Sperrschichttemperatur auf einfache Weise möglich. Insbesondere kann das Regeln der Drehzahl im Zusammenhang der Erfindung ein Begrenzen der Drehzahl bzw. des Drehmoments bedeuten.

In einer bevorzugten Weiterbildung der Erfindung werden für das Verfahren folgende Schritte, bevorzugt in dieser Reihenfolge, durchgeführt:

- Messen der aktuellen Diodenspannung,
- Ermitteln der aktuellen Rekuperationsleistung des Motors,
- Ermitteln eines Leistungsfaktors mittels der Diodenspannung und einer Deratinginformation,
- Bestimmen einer Zielleistung durch Multiplizieren des Leistungsfaktors mit der aktuellen Rekuperationsleistung,
- Bestimmen eines Geschwindigkeitsbegrenzungswerts mittels der Zielleistung,
- Begrenzen der Drehzahl des Motors basierend auf dem Geschwindigkeitsbegrenzungswert.

Erfindungsgemäß ist in der Deratinginformation eine Abhängigkeit zwischen der Sperrschichttemperatur bzw. Diodenspannung und einem Leistungsfaktor hinterlegt. Dabei sind bevorzugt ein unterer Schwellenwert und ein oberer Schwellenwert definiert. Abhängig von der gemessenen Diodenspannung wird der Leistungsfaktor bestimmt. Dieser Leistungsfaktor wird anschließend mit der aktuellen Rekuperationsleistung multipliziert, was dann eine Zielleistung ergibt. Mittels der Zielleistung wird darauf folgend ein Geschwindigkeitsbegrenzungswert berechnet.

Die Berechnungen erfolgen bevorzugt durch eine Recheneinheit. Ein Regelkreis regelt besonders bevorzugt die Drehzahl des Motors gemäß den Berechnungen der Recheneinheit, insbesondere unter Berücksichtigung des Geschwindigkeitsbegrenzungswerts.

Die Stärke des Regeleingriffs nach dem erwähnten Verfahren wird somit abhängig von der Sperrschichttemperatur der Suppressordiode bestimmt. Die Deratinginformation wird dabei so gewählt, dass bei Überschreitung des unteren Schwellenwerts (untere Grenztemperatur) der Regeleingriff aktiv wird und bei Überschreitung des oberen Schwellenwerts (obere, kritische, Grenztemperatur) die Drehzahl maximal reduziert wird, so dass es zu keiner weiteren Erwärmung der Diode mehr kommen kann.

Bei einer Temperaturmessung (bzw. äquivalente Spannungsmessung), welche den unteren Schwellenwert übersteigt, wird also der Regeleingriff bevorzugt in Abhängigkeit von der Rekuperationsleistung des Motors und dem definierten Deratingverhalten (Deratinginformationen) durchgeführt.

In einer bevorzugten Weiterbildung der Erfindung wird das Verfahren nur dann durchgeführt, wenn die Diode leitend ist. Besonders bevorzugt wird in einem Verfahrensschritt ermittelt, ob die Diode leitend ist. Wenn dies der Fall ist, werden die weiteren Verfahrensschritte durchgeführt. Durch ein solches Vorgehen wird sichergestellt, dass der Regeleingriff nicht unnötigerweise geschieht - zum Beispiel, wenn die Diodenspannung den unteren Schwellenwert überschreitet, obwohl die Diode noch nicht leitet.

Der Übergang in einen leitenden Zustand der Diode ist an einem Knickpunkt der Spannung erkennbar. In einer bevorzugten Weiterbildung der Erfindung wird die Leitfähigkeit der Diode mittels folgender Verfahrensschritte bestimmt:

- Ermittlung des aktuellen Rekuperationsstroms des Motors,
- Ermittlung des aktuellen Kondensatorstroms und
- Berechnung des aktuellen Diodenstroms aus dem Rekuperationsstrom und dem Kondensatorstrom.

Dabei wird der Rekuperationsstrom bevorzugt berechnet, insbesondere aus Werten einer Messung der Motorterminalspannungen sowie Werten einer Messung der Motorphasenströme. Weiterhin bevorzugt wird auch der Kondensatorstrom berechnet, insbesondere aus der Steigung der Kondensatorspannung und dem Kapazitätswert des Kondensators.

Besonders bevorzugt wird der Diodenstrom bei Rekuperation aus der Differenz zwischen dem Rekuperationsstrom und dem Kondensatorstrom berechnet. Sobald der berechnete Diodenstrom einen Schwellenwert überschreitet, beginnt die Diode zu leiten und die zugehörige Diodenspannung wird als Kalibrierwert gemessen und gespeichert.

In einer alternativen Weiterbildung der Erfindung wird neben der Suppressordiode auch der Motor genutzt, um elektrische Energie in thermische Energie umzuwandeln. Dazu wird bevorzugt der Blindstrom im Motor erhöht, während gleichzeitig die maximale Rekuperationsleistung gemäß der Deratinginformation reduziert wird. Auf diese Weise muss die Drehzahl des Motors weniger stark limitiert werden und die Dynamik des Bremsvorgangs steigt.

In einer bevorzugten Weiterbildung der Erfindung wird eine Kalibrierung der Suppressordiode durchgeführt, wofür folgende Schritte durchgeführt werden:

- Bestromen der Diode mit einem Strom in Sperrrichtung der Diode,
- Messen der Diodenspannung.

Diese Kalibrierung kann entweder als initiale Kalibrierung oder als regelmäßige Nachkalibrierung ausgebildet sein. Die initiale Kalibrierung verringert den Fehler der Spannungsmessung durch Exemplarstreuung und die Nachkalibrierung verbessert die Genauigkeit der Spannungsmessung bezüglich Alterungsdrift. Durch eine Erhöhung der Genauigkeit der Spannungsmessung wird nicht unnötig früh (also bei unkritischer Diodensperrschichttemperatur) die Motordrehzahl begrenzt.

In einer bevorzugten Weiterbildung der Erfindung ist die Kalibrierung eine initiale Kalibrierung.

Die Messung der Sperrschichttemperatur einer Suppressordiode basiert bevorzugt auf der Temperaturabhängigkeit ihrer Spannungs/Strom-Kennlinie. Es wird insbesondere im Wesentlichen der Quadrant der Kennlinie für den Stromfluss in Sperrrichtung verwendet. Die Zener-Spannung bei geringem Rückwärtsstrom hat eine nahezu lineare Abhängigkeit von der Temperatur. Die Streuung dieser Temperaturabhängigkeit ist außerdem nahezu keiner Exemplarstreuung unterworfen. Dies gilt für Dioden, bei denen der Avalanche-Effekt stärker ausgeprägt ist als der Zener-Effekt (Zenerspannung >> 5V).

Der lineare Zusammenhang kann wie folgt beschrieben werden (für kleine Rückwärtsströme):

$$Uz = f(T)$$

$$Uz(T) = Uzx(Tx)+a*(T-Tx)$$

Dabei ist T die Diodensperrschichttemperatur, Uz die Durchbruchspannung der Suppressordiode, a die Steigung des linearen Spannungs-Temperatur-Zusammenhangs bei geringem Strom, Uzx der Offset des linearen Spannungs-Temperatur-Zusammenhangs bei geringem Strom und Tx der Temperaturwert, für den der Offsetwert Uzx angegeben ist.

Der Offset (Versatz) dieser Funktion ist üblicherweise einer ausgeprägten Exemplarstreuung unterworfen. Um diese Funktion zur Temperaturmessung verwenden zu können, muss der Offset Uzx(Tx) individuell abgeglichen (kalibriert) werden.

Weder die Steigung noch der Offset sind einer nennenswerten Veränderung durch Alterung der Diode unterworfen. Diese Eigenschaft ermöglicht eine initiale Kalibrierung des Offsets z.B. während der Produktion des Steuergeräts.

In einer bevorzugten Weiterbildung der Erfindung wird die initiale Kalibrierung durchgeführt, wenn ein thermisches Gleichgewicht mit der Umgebung hergestellt ist. Zu diesem Zeitpunkt entspricht die Sperrschichttemperatur der Umgebungstemperatur. Bevorzugt wird dann die Diode mit einem kleinen Strom in Sperrrichtung bestromt und gleichzeitig die Diodenspannung gemessen. Insbesondere bevorzugt wird die Diodenspannung mit einem Präzisionsvoltmeter gemessen. Auf diese Weise wird der Offset Uzx(Tx) ermittelt. Die Steigung wird bevorzugt aus dem Datenblatt der Diode entnommen. Insbesondere ist die Steigung als vordefinierter Parameter in einem Speicher abgelegt.

Bei Kalibrierung mit diesem Verfahren ist die Genauigkeit der Temperaturmessung im Betrieb des Steuergeräts nur noch der Genauigkeit der Spannungsmessung des Steuergeräts unterworfen.

$$T = (Uz - Uzx(Tx))/a + Tx$$

$$Genauigkeit(T) = Genauigkeit(Uz)/a$$

Um die Genauigkeit der Temperaturmessung zu verbessern, kann entweder die Genauigkeit der Spannungsmessung im Steuergerät durch Verwendung präziserer Bauteile erhöht werden oder die Funktion Uz(T) im Betrieb regelmäßig nachkalibriert werden (Online-Kalibrierung bzw. Nachkalibrierung).

In einer bevorzugten Weiterbildung der Erfindung ist die Kalibrierung eine regelmäßige Nachkalibrierung. Die beiden Arten der Kalibrierung (initiale Kalibrierung und Nachkalibrierung) können im Verfahren alternativ zueinander oder zusätzlich zueinander eingesetzt werden.

Durch eine regelmäßige Nachkalibrierung wird die Genauigkeit der Spannungsmessung bezüglich der Alterungsdrift verbessert.

Für die regelmäßige Nachkalibrierung wird die Diode kurzzeitig in Sperrrichtung bestromt. Dies geschieht z.B. durch Beschleunigen und schnelles Abbremsen des Motors, was einen Rekuperationspuls auslöst. Während dieses Vorgangs wird die Diodenspannung kontinuierlich gemessen.

Zunächst fließt die Rekuperationsenergie des Motors in den DC-Energiespeicher (üblicherweise Kondensatoren). Die Kondensatoren werden aufgeladen und die Kondensatorspannung steigt. Die Spannung der parallelen Suppressordiode steigt ebenfalls an, jedoch zunächst ohne Stromfluss durch die Diode. Sobald die Kondensatorspannung die Zenerspannung der Diode überschreitet, beginnt ein Rückwärtsstrom durch die Suppressordiode zu fließen. Die Spannung an der Diode bleibt dabei nahezu konstant. Lediglich die Temperaturabhängigkeit der Zenerspannung führt aufgrund der Eigenerwärmung der Diode zu einem sehr geringen Spannungsgradienten. Zur Ermittlung der Zenerspannung der Diode muss die Diodenspannung genau an dem Zeitpunkt gemessen werden, an dem die Diode leitend wird, also genau am Knickpunkt der Spannung. Zur Erkennung, wann die Diode in den leitenden Zustand übergeht, werden die bereits oben beschriebenen Schritte durchgeführt.

Bevorzugt wird zusätzlich der Temperaturwert Tx mit Hilfe einer Referenztemperatur-Messung geschätzt. Dabei wird bevorzugt sichergestellt, dass sich die Diode im Zeitraum vor dem Rekuperationspuls im thermischen Gleichgewicht mit dem Referenztemperatursensor befunden hat.

In gleicher Weise wie bei der initialen Kalibrierung ist nun der Offset Uzx(Tx) der Diodengleichung bekannt.

Die Erfindung betrifft weiterhin ein Drehzahlregelungssystem zur Durchführung des zuvor beschriebenen Verfahrens. Das Drehzahlregelungssystem weist dafür einen Regelkreis sowie eine Recheneinheit auf.

Weiterhin betrifft die Erfindung ein Steuergerät für ein Fahrzeug mit einem zuvor genannten Drehzahlbegrenzungssystem.

Weitere bevorzugte Ausführungsformen ergeben sich auch aus den Unteransprüchen und der nachfolgenden Beschreibung von Ausführungsbeispielen anhand von Figuren.

In schematischer Darstellung zeigen beispielhaft:

Fig. 1    einen beispielhaften Aufbau eines Systems zur Ansteuerung eines dreiphasigen Motors mit Drehzahlregelung bzw. Drehmomentregelung,

Fig. 2    ein beispielhaftes Diagramm zur Abhängigkeit der Zenerspannung von der Temperatur und dem Strom,

Fig. 3    ein beispielhaftes Szenario zum Lösen der Bremse,

Fig. 4    eine beispielhafte Darstellung einer Deratinginformation,

Fig. 5    eine schematische Darstellung des Verfahrens zum Schutz der Diode,

Fig. 6    eine schematische Darstellung des Verfahrens in einer ersten Betriebsweise,

Fig. 7    eine schematische Darstellung des Verfahrens in einer zweiten Betriebsweise und

Fig. 8    eine schematische Darstellung des Verfahrens bei der regelmäßigen Nachkalibrierung.

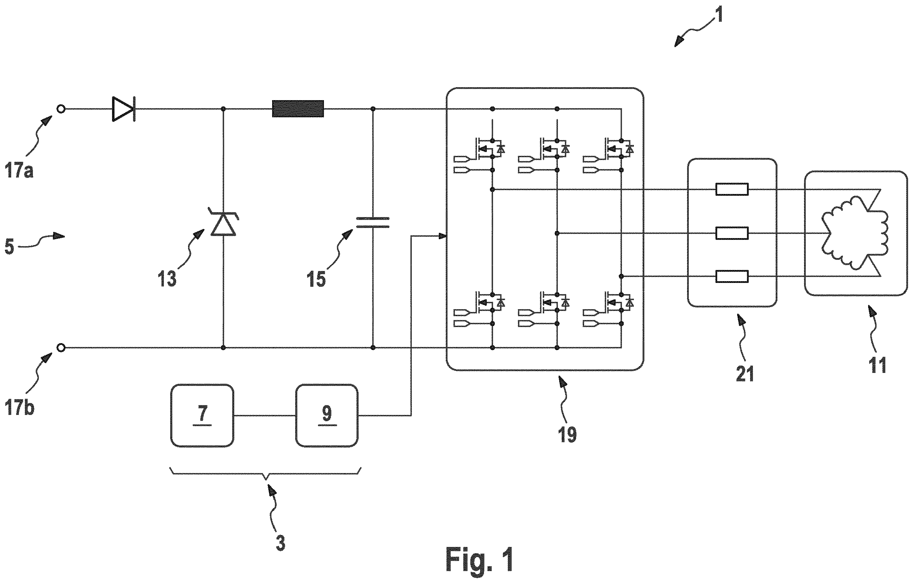

Fig. 1 zeigt ein schematisches und beispielhaftes Drehzahlregelungssystem 1 (System zur Ansteuerung eines dreiphasigen Motors mit Drehzahlregelung) mit einer Recheneinheit 3 und einem Regelkreis 5. Die Recheneinheit 3 umfasst einen Mikroprozessor 7 und eine PWM-Ausgabeeinheit 9. Die PWM-Ausgabeeinheit 9 kann alternativ auch unabhängig von der Recheneinheit 3 implementiert sein. Der Regelkreis zum Ansteuern eines Motors 11 umfasst eine (Suppressor-) Diode 13 zur Begrenzung der Spannung und Umwandlung der Rekuperationsenergie und parallel dazu einen Kondensator 15 zum Stabilisieren der DC-Link-Spannung. Zudem umfasst der Regelkreis Einheiten (nicht dargestellt) zum Messen der Größen Motordrehzahl, Motorposition, DC-Link-Spannung (über den Kondensator 15 und die Diode 13) sowie Phasenströme und Phasenspannungen für die drei Phasen. Ausgehend von den Anschlüssen für die Bordnetzversorgung 17a,b wird eine B6-Brücke 19 betrieben, welche dann über Phasenwiderstände 21 (können auch als Phasenstrommesswiderstände bezeichnet werden) den Motor 11 antreibt. Der Motor 11 ist bevorzugt als dreiphasiger Motor ausgebildet, weshalb die Phasenwiderstände 21 und die B6-Brücke 19 auch jeweils für drei Phasen ausgelegt sind.

Wird das System in der Rekuperation betrieben, so fließt die Rekuperationsenergie vom Motor zunächst in den Kondensator. Dieser wird aufgeladen und die Kondensatorspannung steigt. Durch die parallele Suppressordiode 13 fließt zunächst kein Strom, jedoch steigt die Spannung an. Sobald die Kondensatorspannung die Zenerspannung der Diode überschritten hat, beginnt ein Rückwärtsstrom durch die Suppressordiode 13 zu fließen. Die Spannung an der Diode 13 bleibt dabei nahezu konstant. Allerdings existiert eine Temperaturabhängigkeit der Zenerspannung und führt wegen der Eigenerwärmung der Diode zu einem sehr geringen Spannungsgradienten.

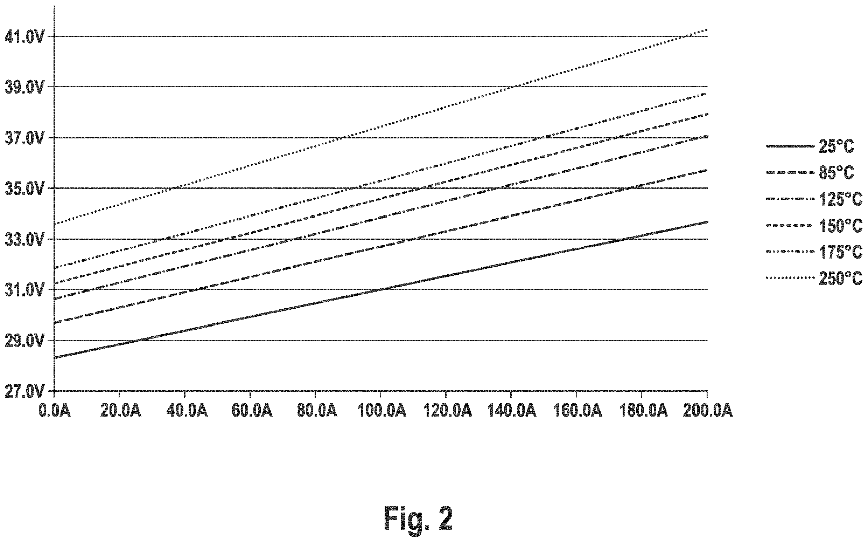

Fig. 2 zeigt die Temperaturabhängigkeit der Spannungs-/Stromkennlinie der Diode. Bevorzugt wird für das Verfahren im Wesentlichen der Quadrant der Kennlinie für Stromfluss in Sperrrichtung verwendet. Die Zenerspannung hat bei geringem Rückwärtsstrom eine nahezu lineare Abhängigkeit von der Temperatur. Die Steigung ist nahezu keiner Exemplarsteuerung unterworfen (für Dioden, bei denen der Avalanche-Effekt größer ist als der Zener-Effekt). Insgesamt bildet dies eine einfache Grundlage für die Temperaturberechnung über die Messung der Zenerspannung bei geringem Rückwärtsstrom.

Der Offset ist jedoch üblicherweise von einer ausgeprägten Exemplarstreuung betroffen. Dieser Offset kann für eine Erhöhung der Genauigkeit des Verfahrens individuell abgeglichen bzw. kalibriert werden.

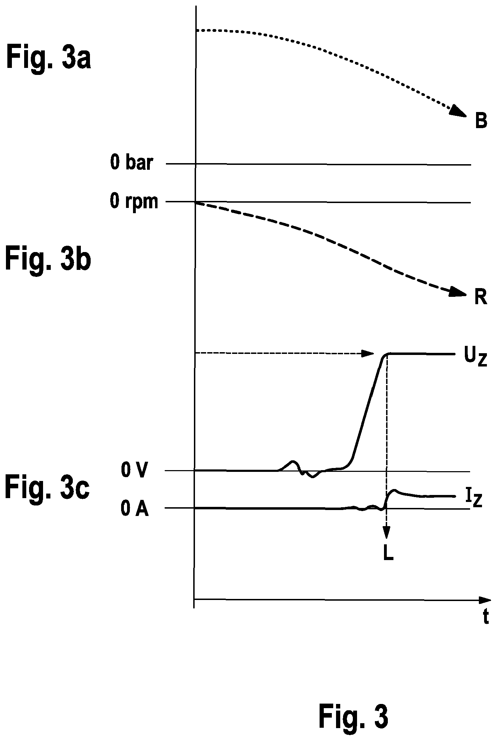

Fig. 3 zeigt ein beispielhaftes Szenario zum Lösen einer Bremse über die Zeit t. Bei Absinken der Rotationsgeschwindigkeit R des Motors (Fig. 3b) sinkt - zumindest relativ gesehen - ebenfalls der Bremsdruck des Motors B (Fig. 3a). Währenddessen steigt die Zenerspannung Uz (gemessen) in der Suppressordiode. Wird ein bestimmter Schwellenwert überschritten, so beginnt die Diode zu leiten (Zeitpunkt L) und die Zenerspannung Uz steigt nicht weiter an. Dies zeigt sich gleichzeitig mit einem schnellen Anstieg des Stroms Iz (berechnet) in der Suppressordiode (Fig. 3c). Alternativ könnte der Strom Iz auch gemessen sein.

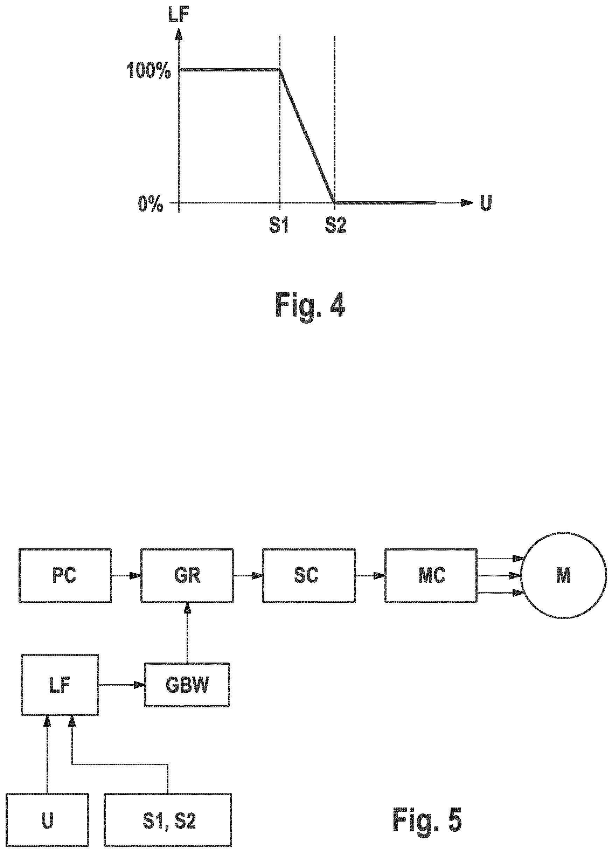

Fig. 4 zeigt eine beispielhafte Darstellung einer Deratinginformation, wie sie für das erfindungsgemäße Verfahren genutzt werden könnte. Aufgetragen ist ein Leistungsfaktor LF auf der y-Achse sowie die Diodenspannung U in Sperrrichtung auf der x-Achse. Die Diodenspannung U (in Sperrrichtung) ist dabei gleichzusetzen mit der Sperrschichttemperatur, die linear mit der Diodenspannung U in Verbindung steht. Bei geringer Spannung findet keine Reduktion des Leistungsfaktors LF statt, so dass die Drehzahl keine Reduktion erfährt. Bei steigender Spannung U wird zunächst ein unterer Schwellenwert S1 überschritten, so dass der geLeistungsfaktor LF beginnt, abzufallen. Der Leistungsfaktor LF bestimmt dabei die Höhe des Geschwindigkeitsbegrenzungswerts, also den Wert, auf den die Rotationsgeschwindigkeit des Motors begrenzt wird. Steigt die Spannung U auf oberhalb eines zweiten Schwellenwertes S2, wird die Drehzahl maximal begrenzt, so dass es zu keiner weiteren Erwärmung der Diode kommen kann.

Fig. 5 zeigt eine schematische Darstellung des Verfahrens zum Schutz der Diode. Der erste und der zweite Schwellenwert S1, S2 sind bevorzugt in einem EEPROM-Speicher abgelegt. Mittels der Schwellenwerte S1, S2 und der Messung der aktuellen Diodenspannung U wird der Leistungsfaktor LF bestimmt, woraus ein Geschwindigkeitsbegrenzungswert GBW abgeleitet wird. Für den Fall, dass der von der Drucksteuerungseinheit PC angeforderte Geschwindigkeitssollwert betraglich größer als der Geschwindigkeitsbegrenzungswert GBW ist, so wird dann Geschwindigkeitssollwert auf den Geschwindigkeitsbegrenzungswert GBW reduziert. Der Geschwindigkeitssollwert wird anschließend an den Geschwindigkeitscontroller SC übermittelt, der aus dem Geschwindigkeitssollwert einen Momentensollwert berechnet. Der Motorcontroller berechnet aus dem Momentensollwert schließlich eine geeignete elektrische Ansteuerung des Motors.

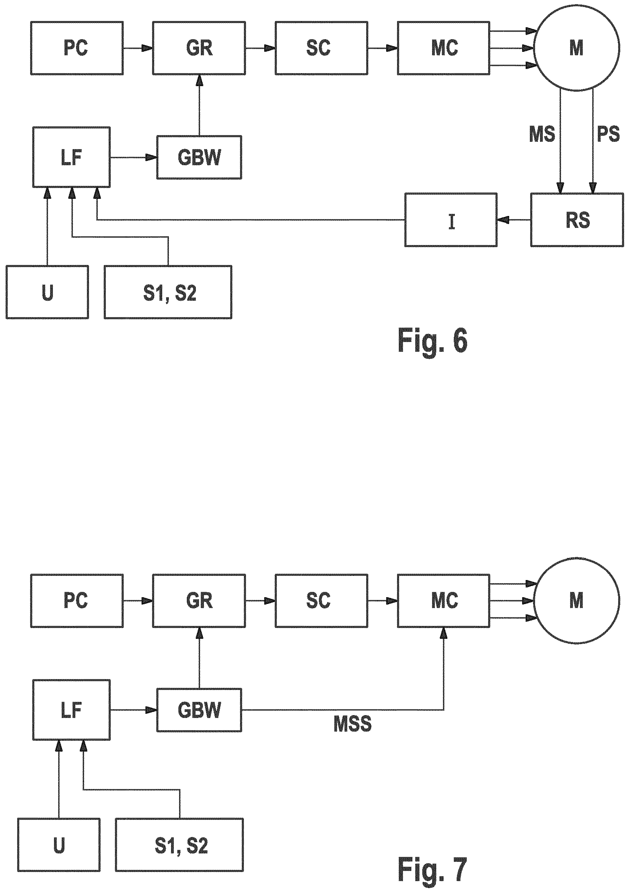

Fig. 6 zeigt eine schematische Darstellung des Verfahrens in einer ersten Betriebsweise, wobei bei dieser ersten Betriebsweise das Verfahren nur durchgeführt wird, wenn die Diode leitend ist.

Zusätzlich zur Diodenspannung U und den Schwellenwerten S1, S2 geht hierbei auch der Diodenstrom I ein. Für die Berechnung des Diodenstroms I werden ein Rekuperationsstrom RS und ein Kondensatorstrom I_C bestimmt. Der Rekuperationsstrom RS wird - vorzugsweise in der Recheneinheit, die insbesondere ein Mikrocontroller ist - berechnet aus der Messung der drei Motorterminalspannungen MS und der Messung der Motorphasenströme PS. Der Kondensatorstrom wird berechnet aus der Steigung der Kondensatorspannung (vor dem Erreichen der Zenerspannung) und dem Kapazitätswert des Kondensators: $I\_C = C* (dU/dt)$. Die Differenz aus dem Rekuperationsstrom RS und dem Kondensatorstrom I_C ergibt den Diodenstrom I. Sobald der Diodenstrom I einen Schwellenwert überschreitet, beginnt die Diode zu leiten.

Fig. 7 zeigt eine schematische Darstellung des Verfahrens in einer zweiten Betriebsweise, wobei bei dieser zweiten Betriebsweise das Verfahren derart durchgeführt wird, dass auch mittels des Motors Rekuperationsenergie in thermische Energie umgewandelt wird.

Als Variante zu Fig. 6 wird der minimale Motor-Blindstrom MSS ausgehend von den Berechnungen um den Geschwindigkeitbegrenzungswert GWB an den Motorcontroller übermittelt. In diesem zweiten Betriebsmodus ist die grundlegende Idee, dass der Blindstrom im Motor erhöht wird, während gleichzeitig die maximale Rekuperationsleistung gemäß der Deratinginformation reduziert wird. Im Vergleich zu Fig. 5 wird in der Variante von Fig. 6 also neben der Begrenzung der Motorsollgeschwindigkeit zusätzlich der Blindstrom im Motor erhöht. Durch die Erhöhung des Blindstroms im Motor kann gleichzeitig der Geschwindigkeitbegrenzungswert GWB reduziert werden.

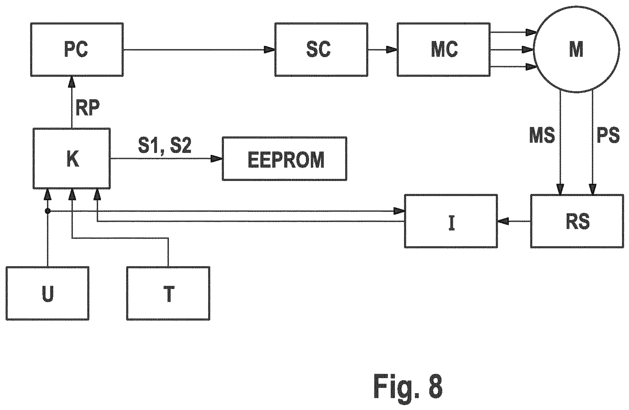

Fig. 8 zeigt eine schematische Darstellung des Verfahrens bei der regelmäßigen Nachkalibrierung. Für die Kalibrierung wird ein Rekuperationspuls RP generiert, welcher der Drucksteuerungseinheit PC zugeführt wird. Dieser Rekuperationspuls RP ist ein Testpuls, der die Diode kurzzeitig in Sperrrichtung bestromt. Dadurch können verschiedene Parameter gemessen werden, z.B. die Motorphasenströme PS sowie die drei Motorterminalspannungen MS, aus denen der Diodenstrom I berechnet wird. In die Kalibrierung K der Diode gehen verschiedene Werte ein, z.B. die Diodenspannung U und eine Diodentemperatur (Sperrschichttemperatur) T sowie ein Diodenstrom I. Die durch die Kalibrierung K berechneten Schwellenwerte S1, S2 werden in einem Speicher EEPROM gespeichert.

Alternativ oder zusätzlich zu der regelmäßigen Nachkalibrierung ist eine initiale Kalibrierung vorgesehen, welche insbesondere während der Produktion des Steuergeräts durchgeführt wird.

Bezugszeichenliste:

| | |
|---|---|
| 1 | Drehzahlregelungssystem |
| 3 | Recheneinheit |
| 5 | Regelkreis |
| 7 | Mikroprozessor |
| 9 | PWM-Ausgabeeinheit |
| 11 | Motor |
| 13 | Suppressordiode |
| 15 | Kondensator |
| 17a,b | Bordnetzversorgung |
| 19 | B6-Brücke |
| 21 | Phasenwiderstände |
| S1 | erster Schwellenwert |
| S2 | zweiter Schwellenwert |
| PC | Drucksteuerungseinheit |
| GR | Geschwindigkeitsreduktion |
| SC | Geschwindigkeitscontroller |
| MC | Motorcontroller |
| M | Motor |
| LF | Leistungsfaktor |
| GBW | Geschwindigkeitsbegrenzungswert |
| U | Diodenspannung in Sperrrichtung |
| I | Diodenstrom in Sperrrichtung |
| RS | Rekuperationsstrom |
| MSS | Motor-Blindstrom |
| MS | Motorterminalspannungen |
| PS | Motorphasenströme |
| EEPROM | Speicher |
| K | Kalibrierung |
| T | Dioden(sperrschicht)temperatur |
| RP | Rekuperationspuls |

**Patentansprüche**

1. Verfahren zum Regeln der Drehzahl oder des Drehmoments eines Motors zum Schutz einer Suppressordiode (13) in einem Steuergerät eines Fahrzeugs, wobei die Suppressordiode (13) Rekuperationsenergie des Motors (11) in thermische Energie umwandelt, **dadurch gekennzeichnet, dass** für das Verfahren folgende Schritte durchgeführt werden:

   - Ermitteln der aktuellen Sperrschichttemperatur (T) und/oder Diodenspannung (U) der Suppressordiode (13),
   - Regeln der Drehzahl oder des Drehmoments des Motors (11) mittels der aktuellen Sperrschichttemperatur (T) und/oder Diodenspannung (U) derart, dass die Sperrschichttemperatur (T) der Suppressordiode (13) einen vorbestimmten Sperrschichttemperaturgrenzwert nicht überschreitet, wobei

zur Durchführung des Verfahrens eine Deratinginformation herangezogen wird und wobei in der Deratinginformation eine Abhängigkeit zwischen der Sperrschichttemperatur (T) bzw. Diodenspannung (U) und einem Leistungsfaktor (LF) hinterlegt ist.

2. Verfahren nach Anspruch 1, **dadurch gekennzeichnet, dass** zur Durchführung des Verfahrens die aktuelle Rekuperationsleistung herangezogen wird.

3. Verfahren nach einem der vorhergehenden Ansprüche, **dadurch gekennzeichnet, dass** für das Verfahren folgende Schritte durchgeführt werden:

- Messen der aktuellen Diodenspannung (U),
- Ermitteln der aktuellen Rekuperationsleistung des Motors (11),
- Ermitteln eines Leistungsfaktors (LF) mittels der Diodenspannung (U) und einer Deratinginformation,
- Bestimmen einer Zielleistung durch Multiplizieren des Leistungsfaktors (LF) mit der aktuellen Rekuperationsleistung,
- Bestimmen eines Geschwindigkeitsbegrenzungswerts (GBW) mittels der Zielleistung,
- Begrenzen der Drehzahl des Motors (11) basierend auf dem Geschwindigkeitsbegrenzungswert (GBW).

4. Verfahren nach einem der vorhergehenden Ansprüche, wobei bestimmt wird, ob die Suppressordiode (13) leitend ist und wobei das Verfahren nur durchgeführt wird, wenn die Suppressordiode (13) leitend ist.

5. Verfahren nach einem der vorhergehenden Ansprüche, **dadurch gekennzeichnet, dass** mittels des Motors (11) Rekuperationsenergie in thermische Energie umgewandelt wird.

6. Verfahren nach einem der vorhergehenden Ansprüche, **dadurch gekennzeichnet, dass** eine Kalibrierung der Suppressordiode (13) durchgeführt wird, wofür folgende Schritte durchgeführt werden:

- Bestromen der Suppressordiode (13) mit einem Strom (I) in Sperrrichtung der Suppressordiode (13),
- Messen der Diodenspannung (U),
- Messen der Sperrschichttemperatur (T).

7. Verfahren nach Anspruch 6, **dadurch gekennzeichnet, dass** die Kalibrierung als regelmäßige Nachkalibrierung durchgeführt wird.

8. Drehzahlregelungssystem (1) zur Ansteuerung eines dreiphasigen Motors mit Drehzahlregelung, aufweisend einen Regelkreis (5) sowie eine Recheneinheit (3), ausgebildet zur Durchführung eines Verfahrens nach einem der vorhergehenden Ansprüche, wobei der Regelkreis (5) die Drehzahl des Motors gemäß den Berechnungen der Recheneinheit (3) regelt.

9. Steuergerät für ein Fahrzeug, umfassend ein Drehzahlregelungssystem (1) nach Anspruch 8.


**Claims**

1. Method for controlling the rotational speed or torque of a motor in order to protect a suppressor diode (13) in a control unit of a vehicle, wherein the suppressor diode (13) converts recuperation energy of the motor (11) into thermal energy, **characterized in that** the following steps are carried out for the method:

- determining the current junction temperature (T) and/or diode voltage (U) of the suppressor diode (13),
- controlling the rotational speed or the torque of the motor (11) by means of the current junction temperature (T) and/or diode voltage (U) in such a way that the junction temperature (T) of the suppressor diode (13) does not exceed a predetermined junction temperature limit value, wherein

derating information is used to carry out the method, and wherein a dependency between the junction temperature (T) or diode voltage (U) and a power factor (LF) is stored in the derating information.

2. Method according to Claim 1, **characterized in that** the current recuperation power is used to carry out the method.

3. Method according to either of the preceding claims, **characterized in that** the following steps are carried out for the method:

   - measuring the current diode voltage (U),
   - determining the current recuperation power of the motor (11),
   - determining a power factor (LF) using the diode voltage (U) and derating information,
   - determining a target power by multiplying the power factor (LF) by the current recuperation power,
   - determining a speed limit value (GBW) by means of the target power,
   - limiting the rotational speed of the motor (11) on the basis of the speed limit value (GBW).

4. Method according to one of the preceding claims, wherein it is determined whether the suppressor diode (13) is conductive, and wherein the method is carried out only if the suppressor diode (13) is conductive.

5. Method according to one of the preceding claims, **characterized in that** recuperation energy is converted into thermal energy by means of the motor (11).

6. Method according to one of the preceding claims, **characterized in that** the suppressor diode (13) is calibrated, for which the following steps are carried out:

   - energizing the suppressor diode (13) with a current (I) in the reverse direction of the suppressor diode (13),
   - measuring the diode voltage (U),
   - measuring the junction temperature (T).

7. Method according to Claim 6, **characterized in that** the calibration is carried out as a regular recalibration.

8. Rotational speed control system (1) for actuating a three-phase motor with rotational speed control, comprising a control loop (5) and a computing unit (3), designed for carrying out a method according to one of the preceding claims, wherein the control loop (5) controls the rotational speed of the motor in accordance with the calculations of the computing unit (3).

9. Control unit for a vehicle, comprising a rotational speed control system (1) according to Claim 8.

**Revendications**

1. Procédé de régulation de la vitesse de rotation ou du couple d'un moteur pour protéger une diode de suppression (13) dans un module de commande d'un véhicule, la diode de suppression (13) convertissant l'énergie de récupération du moteur (11) en énergie thermique, **caractérisé en ce que**, pour le procédé, les étapes suivantes sont exécutées :

   - détermination de la température de couche de jonction (T) et/ou de la tension de diode (U) actuelle de la diode de suppression (13),
   - régulation de la vitesse de rotation ou du couple du moteur (11) au moyen de la température de couche de jonction (T) et/ou de la tension de diode (U) actuelle de telle sorte que la température de couche de jonction (T) de la diode de suppression (13) ne dépasse pas une valeur limite de température de couche de jonction prédéterminée,

   une information de déclassement étant utilisée pour la mise en oeuvre du procédé et une dépendance entre la température de couche de jonction (T) ou la tension de diode (U) et un facteur de puissance (LF) étant mémorisée dans l'information de déclassement.

2. Procédé selon la revendication 1, **caractérisé en ce que** la puissance de récupération actuelle est utilisée pour la mise en oeuvre du procédé.

3. Procédé selon l'une des revendications précédentes, **caractérisé en ce que** les étapes suivantes sont exécutées pour le procédé :

   - mesure de la tension de diode (U) actuelle,

- détermination de la puissance de récupération actuelle du moteur (11),
- détermination d'un facteur de puissance (LF) au moyen de la tension de diode (U) et d'une information de déclassement,
- spécification d'une puissance cible en multipliant le facteur de puissance (LF) par la puissance de récupération actuelle,
- spécification d'une valeur de limitation de vitesse (GBW) au moyen de la puissance cible,
- limitation de la vitesse de rotation du moteur (11) sur la base de la valeur de limitation de vitesse (GBW).

**4.** Procédé selon l'une des revendications précédentes, une détermination étant effectuée afin de vérifier si la diode de suppression (13) est conductrice et le procédé n'étant mis en oeuvre que si la diode de suppression (13) est conductrice.

**5.** Procédé selon l'une des revendications précédentes, **caractérisé en ce que** l'énergie de récupération est transformée en énergie thermique au moyen du moteur (11).

**6.** Procédé selon l'une des revendications précédentes, **caractérisé en ce qu'**un étalonnage de la diode de suppression (13) est effectué, pour lequel les étapes suivantes sont exécutées :

- alimentation en courant de la diode de suppression (13) avec un courant (I) dans le sens du blocage de la diode de suppression (13),
- mesure de la tension de diode (U),
- mesure de la température de couche de jonction (T).

**7.** Procédé selon la revendication 6, **caractérisé en ce que** l'étalonnage est effectué en tant que réétalonnage régulier.

**8.** Système de régulation de vitesse de rotation (1) destiné à la commande d'un moteur triphasé avec régulation de la vitesse de rotation, possédant un circuit de régulation (5) ainsi qu'une unité de calcul (3), configuré pour mettre en oeuvre un procédé selon l'une des revendications précédentes, le circuit de régulation (5) régulant la vitesse de rotation du moteur selon les calculs de l'unité de calcul (3).

**9.** Module de commande pour un véhicule, comprenant un système de régulation de vitesse de rotation (1) selon la revendication 8.

Fig. 1

Fig. 2

**Fig. 3a**

**Fig. 3b**

**Fig. 3c**

**Fig. 3**

EP 3 850 748 B1

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017085208 A1
- DE 102017103573 A1
- WO 2011073829 A1